## Europäisches Patentamt

## European Patent Office

## Office européen des brevets

(11) Veröffentlichungsnummer: **0 016 386**
**B1**

(12) **EUROPÄISCHE PATENTSCHRIFT**

(45) Veröffentlichungstag der Patentschrift: 09.10.85

(51) Int. Cl.⁴: **H 01 L 29/60, G 11 C 11/34**

(21) Anmeldenummer: **80101184.2**

(22) Anmeldetag: **07.03.80**

(54) Umprogrammierbare Halbleiter-Speicherzelle vom Floating-Gate-Typ.

(30) Priorität: 07.03.79 DE 2908796

(43) Veröffentlichungstag der Anmeldung:
01.10.80 Patentblatt 80/20

(45) Bekanntmachung des Hinweises auf die
Patenterteilung:
09.10.85 Patentblatt 85/41

(84) Benannte Vertragsstaaten:
FR GB

(56) Entgegenhaltungen:
US-A-3 919 711
US-A-4 016 588

IEEE INTERNATIONAL SOLID-STATE CIRCUITS
CONFERENCE, Band XXII, Februar 1979, New
York, US, T. HAGIWARA et al.: "A 16Kb
electrically erasable programmable ROM",
Seiten 50, 51, 277

(73) Patentinhaber: **Siemens Aktiengesellschaft
Berlin und München Wittelsbacherplatz 2
D-8000 München 2 (DE)**

(72) Erfinder: **Giebel, Burkhard, Dipl.-Ing.
Asenweg 15
D-8000 München 83 (DE)**
Erfinder: **Scheibe, Adolf, Dr. Ing. Dipl.-Phys.
Finkenstrasse 9a
D-8012 Ottobrunn (DE)**

(56) Entgegenhaltungen:
**PATENT ABSTRACTS OF JAPAN, Band 2, Nr.
120, 6. Oktober 1978, Seite 6976, Tokyo, JP
IBM TECHNICAL DISCLOSURE BULLETIN,
Band 17, Januar 1975, New York, US, S.
DASGUPTA et al.: "Dual-gate famos memory
cell", Seite 2266**

# 0 016 386

**Beschreibung**

Die Erfindung betrifft eine umprogrammierbare Halbleiter-Speicherzelle nach dem Oberbegriff des Patentanspruches 1. Eine solche ist z.B. in dem unter dem Titel "Electrically Erasable and Reprogrammable Read-Only Memory Using the n-Channel SIMOS One-Transistor Cell" in "IEEE Trans. on Electron Devices" Vol. ED-24, No. 5, Mai 1977, Seiten 606—610, veröffentlichten Aufsatz beschrieben.

Gemäß dem gleichfalls in dieser Literaturstelle, Seiten 600 ff. erschienenen Aufsatz "Technology of a New n-Channel One-Transistor EAROM Cell Called SIMOS" ist dabei der beim Programmieren dieser Speicherzellen erreichte Einsatzspannungsshub $\Delta U_T$, d.h. die Einsatzspannungsverschiebung gemäß der Beziehung

$$\Delta U_T = U_P - U'_{DS} \cdot \frac{C_{FS} + C_{FD} + C_{FSub} + C_{FC}}{C_{FC}} \tag{1}$$

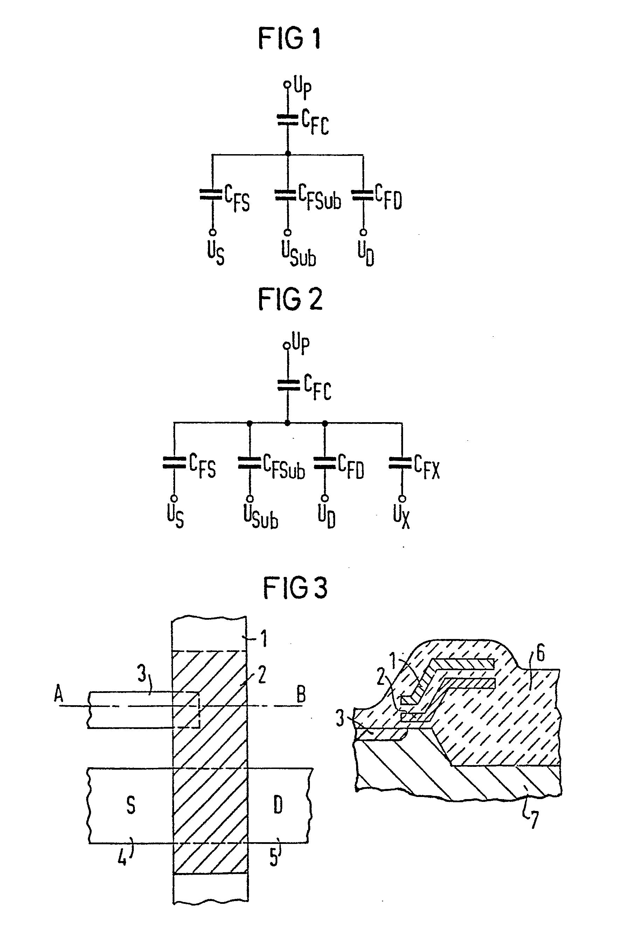

im wesentlichen eine Funktion der in der $Si^2$-Gate-Struktur enthaltenen, in Fig. 1 im Ersatzschaltbild dargestellten Koppelkapazitäten. Es bedeutet dabei:

$U_S$ = am Sourceanschluß anliegende Spannung

$U_{Sub}$ = am Substrat anliegende Spannung

$U_D$ = am Drainanschluß anliegende Spannung

$U_P$ = Programmierspannung am Steuergate

$U'_{DS}$ = das auf Source bezogene Potential des Kanalabschnittes, von dem aus die Ladungsträgerinjektion auf das Floating-Gate erfolgt

$C_{FS}$ = Koppelkapazität zwischen Floating-Gate und Source

$C_{FD}$ = Koppelkapazität zwischen Floating-Gate und Drain

$C_{FC}$ = Koppelkapazität zwischen Steuergate und Floating Gate

$C_{FSub}$ = Koppelkapazität zwischen Floating-Gate und Substrat.

Ein hoher Einsatzspannungshub $\Delta U_T$ erfordert demzufolge auch eine hohe Koppelkapazität $C_{FC}$ und damit z.B. eine große Überlappfläche zwischen dem im folgenden ausschließlich als Floating-Gate bezeichneten schwebenden Gate und dem Steuergate. Der Verkleinerung der je Speicherzelle erforderlichen Fläche und damit einer Erhöhung der Speicherdichte sind folglich enge Grenzen gesetzt.

Der vorliegenden Erfindung liegt die Aufgabe zugrunde, eine Halbleiter-Speicherzelle der eingangs genannten Art zu schaffen.

1. Bei der bei gleichem Einsatzspannungshub $\Delta U_T$ die Koppelkapazität $C_{Fc}$ zwischen dem Floating-Gate und Steuergate bzw. die Überlappfläche zwischen diesen beiden Gates verringert ist oder

2. bei der bei gleicher Überlappfläche zwischen den beiden Gates der Einsatzspannungshub $\Delta U_T$ erhöht wird oder

3. bei der bei gleichem Einsatzspannungshub $\Delta U_T$ und gleicher Überlappfläche zwischen den beiden Gates die Programmierspannung $U_P$, d.h. die zum Einschreiben der Information in die Speicherzellen erforderliche Steuergate-Spannung, erniedrigt wird.

Bei einer gattungsgemäßen Halbleiter-Speicherzelle schlägt die Erfindung zur Lösung dieser Aufgabe einen zusätzlichen Potentialträger vor, durch den ein weiteres Potential $U_X$ während des Programmierens kapazitiv an das Floating-Gate ankoppelbar ist (siehe Fig. 2).

Da hierbei gilt:

$$\Delta U_T = U_P - U'_{DS} \cdot \frac{C_{FS} + C_{FD} + C_{FSub} + C_{FC} + C_{FX}}{C_{FC}} + U_X \frac{C_{FX}}{C_{FC}} \tag{2}$$

bewirkt der zusätzliche Potentialträger eine Erhöhung des Einsatzspannungshubes $\Delta U_T$ um den Betrag

$$(U_X - U'_{DS}) \cdot \frac{C_{FX}}{C_{FC}} \tag{3}$$

wobei $C_{FX}$ = Koppelkapazität zwischen Floating-Gate und zusätzlichem Potentialträger.

Wird auf eine Vergrößerung des Einsatzspannungshubes $\Delta U_T$ verzichtet, so kann gemäß Beziehung (2) entweder die Programmierspannung $U_P$ oder über die Koppelkapazität $C_{FC}$ die Fläche der Speicherzellen verringert werden, was die Schaffung von Festwertspeichern mit höherer Speicherdichte ermöglicht.

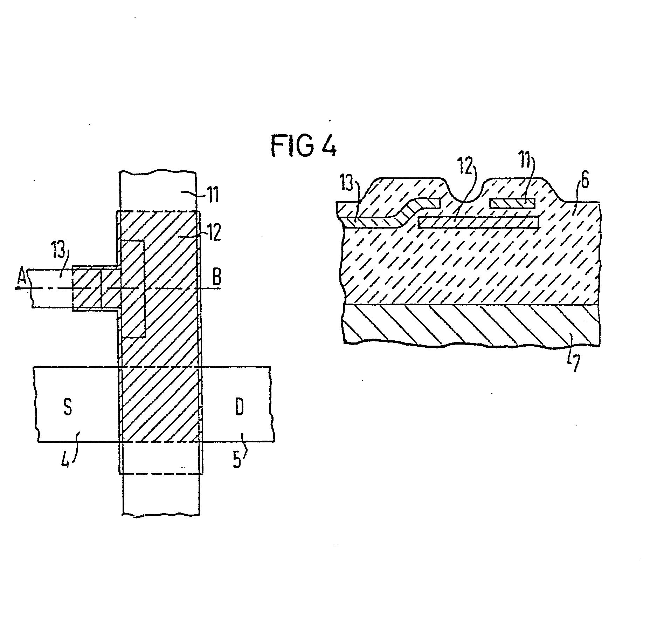

Aus der DE—OS 22 01 028 ist bereits eine Halbleiterspeicherzelle der eingangs genannten Art bekannt. Dort wird eine Halbleiterspeicherzelle mit Floating-Gate, Source und Drain vorgestellt, die zusätzlich eine Elektrode und eine elektrisch leitende Lage ("dritte Gate-Elektrode") aufweist. Diese zusätzliche, elektrisch leitende Lage ist oberhalb des Floating-Gates, außerhalb eines Bereiches zwischen Source und Drain (=Kanal) angeordnet. Dies ist ersichtlich aus der DE—OS 22 01 028, Fig. 4 in Verbindung mit S. 11, zweiter Absatz bis S. 13.

2

0 016 386

Im Gegensatz zum Gegenstand der vorliegenden Erfindung wird jedoch an diese elektrisch leitende Lage nicht ein weiteres Potential angelegt, sondern eine der auch anderweitig verwendeten Versorgungsspannungen.

Ein grundlegender Unterschied liegt auch im verwendeten Arbeitsprinzip bei der bekannten Halbleiter-Speicherzelle: es wird das Prinzip des Lawinendurchbruches (Avalanche Breakdown) verwendet. Das Laden bzw. Entladen des Floating-Gates wird unter Anlegen von Versorgungspotentialen (Erdpotential, Versorgungsspannung) an die dritte Gate-Elektrode durch Lawinendurchbruch vom Floating-Gate in Source und Drain bzw. umgekehrt durchgeführt. Dabei fließt kein Strom zwischen Source und Drain. Beim Gegenstand der vorliegenden Erfindung wird das Programmieren jedoch durch einen hohen Stromfluß zwischen Source und Drain mittels Kanalinjektion in das Floating-Gate erreicht, wobei erfindungsgemäß das an den zusätzlichen Potentialträger (3, 13) angelegte weitere Potential $U_X$ kapazitiv an das Floating-Gate angekoppelt wird. Vor der Verwendung dieses Ladungsübertragungsmechanismus bei der bekannten Halbleiterspeicherzelle wird in der DE—OS 22 01 028 ausdrücklich gewarnt (Zerstörung der Speicherzelle).

Aus dem Dokument JP—A—53-86179 ist eine Halbleiterspeicherzelle bekannt mit Source, Drain, Floating-Gate und Steuergate. Zusätzlich ist unter den beiden Gates jedoch außerhalb des Kanalbereiches zwischen Source und Drain, eine zusätzliche Lage angeordnet. Das Laden bzw. Entladen erfolgt jedoch weder über Source bzw. Drain zum bzw. vom Floating-Gate (Lawinendurchbruch) noch innerhalb des Kanalbereiches (Kanalinjektion), sondern außerhalb dieses Bereiches direkt von der zusätzlichen Lage aus in das Floating-Gate bzw. umgekehrt.

Keine dieser bekannten Halbleiterspeicherzellen löst also die gestellte Aufgabe.

Nachstehend werden anhand der Figuren 3 bis 4 geeignete Beispiele nach der Erfindung zur Schaffung zusätzlicher Potentialträger erläutert. Die jeweils linke Seite einer Figur stellt die Draufsicht und ihre jeweils rechte Seite einen Schnitt gemäß der Linie A—B durch die gebrochen veranschaulichte Speicherzelle vom Floating-Gate-Typ dar.

1. Ausführungsbeispiel (siehe Fig. 3)

Die Speicherzelle weist ein Halbleiter-Substrat 7 auf, das in üblicher Weise mit Source 4 und Drain 5 ausgebildet ist und eine auf diese Substrat aufgebrachte Isolier-, insbesondere $SiO_2$-Schicht 6 mit in dieser Schicht angeordnetem Steuergate 1 und Floating-Gate 2 trägt. Versetzt zur Source 4 ist an das Floating-Gate 2 ein zusätzliches, als Potentialträger dienendes Diffusionsgebiet 3 kapazitiv angekoppelt, durch das bei Anlegen von Spannung der Einsatzspannungshub $\Delta U_T$ um den Betrag

$$(U_X - U'_{DS}) \cdot \frac{C_{FX}}{C_{FC}} \tag{4}$$

erhöht wird. Die hohe Koppelkapazität zwischen dem Floating-Gate und dem zusätzlichen Diffusionsgebiet 3 wird dabei durch die Verringerung der Oxiddicke zwischen dem Diffusiongebiet 3 und dem Floating-Gate 2 erzielt.

Geeignet ist diese Speicherzelle beispielsweise als elektrisch löschbare SIMOS-Speicherzelle (EEPROM oder EAROM Anwendung) mit gesondertem Lösch-Diffusionsgebiet.

2. Ausführungsbeispiel (siehe Fig. 4)

Diese Figur zeigt gleichfalls eine Speicherzelle mit einem Steuergate 11 und einem Floatin-Gate 12. Zur Erhöhung des Einsatzspannungshubes $\Delta U_T$ ist eine Si-Elektrode 13 zusätzlich an das Floating-Gate 12 kapazitiv angekoppelt. Der Einsatzspannungshub vergrößert sich dabei um den im Beispiel 1 bereits genannten Betrag.

**Patentansprüche**

1. Umprogrammierbare Halbleiter-Speicherzelle, bestehend aus einem Halbleitersubstrat (7) mit einer Sourceregion (4) und einer Drainregion (5), einer auf das Halbleitersubstrat (7) aufgebrachten Isolierschicht (6), einem Floating-Gate (2, 12) und einem Steuergate (1, 11), die mittels Kanalinjektion programmierbar ist, gekennzeichnet durch einen zusätzlichen Potentialträger (3, 13), durch den ein weiteres Potential $U_X$ während des Programmierens kapazitiv an das Floating-Gate (2, 12) ankoppelbar ist.

2. Halbleiter-Speicherzelle nach Anspruch 1, dadurch gekennzeichnet, daß der zusätzliche Potentialträger (3, 13) aus einem gesonderten Diffusionsgebiet besteht.

3. Halbleiter-Speicherzelle nach Anspruch 1, dadurch gekennzeichnet, daß der zusätzliche Potentialträger (3, 13) aus einer Si-Elektrode besteht.

**Revendications**

1. Cellule de mémoire à semiconducteurs reprogrammable, constituée par un substrat semiconducteur (7) comportant une région de source (4) et une région de drain (5), une couche isolante (6) déposée sur le

3

substrat semiconducteur (7), une grille flottante (2, 12) et une grille de commande (1, 11), et qui est programmable au moyen d'une injection de canal, caractérisée par un élément supplémentaire d'application de potentiel (3, 13), à l'aide duquel un autre potential $U_x$ peut être accouplé de façon capacitive à la grille flottante (2, 12) pendant la programmation.

2. Cellule de mémoire à semiconducteurs suivant la revendication 1, caractérisé par le fait que l'élément supplémentaire d'application de potentiel (3, 13) est constitué par une région diffusée particulière.

3. Cellule de mémoire à semiconducteurs suivant la revendication 1, caractérisée par le fait que l'élément supplémentaire d'application de potentiel (3, 13) est constitué par une électrode en Si.

**Claims**

1. An erasably programmable semiconductor memory cell consisting of a semiconductor substrate (7) having a source region (4) and a drain region (5), an insulating layer (6), which is placed on the semiconductor substrate (7), a floating gate (2, 12), and a control gate (1, 11), which memory cell is programmable by means of channel injection, characterised by an additional potential carrier (3, 13), by means of which a further potential $U_x$ can be capacitively coupled to the floating gate (2, 12) during programming.

2. A semiconductor memory cell as claimed in Claim 1, characterised in that the additional potential carrier (3, 13) consists of a separate diffusion region.

3. A semiconductor memory cell as claimed in Claim 1, characterised in that the additional potential carrier (3, 13) consisting of a Si-electrode.

0 016 386

FIG 1

FIG 2

FIG 3

FIG 4